# EUROPEAN PATENT SPECIFICATION

(11) **EP 1 448 489 B1**
(45) Date of publication and mention of the grant of the patent: **25.08.2010**
(21) Application number: 02803638.2
(22) Date of filing: 15.11.2002
(51) Int. Cl.: G01N 27/26

(54) **FLEXIBLE SENSOR AND METHOD OF FABRICATION**
FLEXIBLER SENSOR UND HERSTELLUNGSVERFAHREN
CAPTEUR FLEXIBLE ET PROCEDE DE PRODUCTION

(30) Priority: 16.11.2001 US 332194 P
(43) Date of publication of application: 25.08.2004
(73) Proprietor: Ufer, Stefan, Raleigh, NC 27601-1529 (US); F. Hoffmann-La Roche AG, 4070 Basel (CH); Roche Diagnostics GmbH, 68305 Mannheim (DE)
(72) Inventor: UFER, Stefan, Raleigh NC 27601-1529 (US); WILSEY, Christopher, Douglas, Carmel, IN 46032 (US)
(74) Representative: Silber, Anton
(86) International application number: PCT/US2002/036774
(87) International publication number: WO 2003/043945

(56) References cited:
- WO-A-01/25775
- US-A- 4 946 524
- US-A- 5 437 999
- US-A- 6 103 033

## Description

### Government Rights

Work related to the invention was sponsored by the NSF CECT under Grant No. CDR-8622201. The United States Government has certain rights to this invention.

### Related Applications

This application claims priority to U.S. Provisional Application Serial Number 60/332,194, filed November 16, 2001, the contents of which are hereby incorporated by reference as if recited in full herein.

### Field of the Invention

The present invention relates to methods for fabricating electrochemical sensors or wells on flexible substrates and associated products. The products may be particularly suitable for use as disposable biomedical sensors.

### Background of the Invention

Probes or sensors used in medical diagnostic or evaluation procedures often use electrochemical detection provided by dry or fluid/liquid chemistries/electrolytes placed on top of electrodes formed of precious metals (gold, platinum, etc). The probes or sensors can employ chemistries/electrolytes such as solid potassium chloride (such as for reference electrodes) or other chemicals, hydrogels (sometimes containing an internal electrolyte underneath the membrane of an ion-sensitive electrode), or enzyme-containing material. The sensors or probes also typically employ wells or small pools, some of which can be configured to act as capillary spaces to guide quantities of a sample solution (such as blood) to and/or from the electrodes on the probe or sensor.

For many of these applications, the wells are patterned into materials which are selected so that they are compatible with flexible substrates such as polyimide films (Kapton®, Upilex®, and the like). In the past, thin film processing techniques have had problems generating coatings thick enough for proper well formation in chemical sensor applications. In addition, screen printed materials used with thick film processing techniques may be either incompatible with flexible materials or inhibit the formation of fine line resolution desired for small or miniaturized electrodes.

Cosofret et al., in Microfabricated Sensor Arrays Sensitive to pH and K+ for Ionic Distribution Measurements in the Beating Heart, 67 Anal. Chem., pp. 1647-1653 (1995), described spin-coating a polyimide layer of about 30µm onto a film or substrate. Unfortunately, spin-coating methods can, as a practical matter, limit the well depth and/or precise boundary or perimeter definition during formation. In addition, spin-coating methods may be limited to batch fabrication processes and are generally not commercially compatible with high volume, low-cost (continuous or semi-continuous) mass production methods. In view of the foregoing, there is a need for improved, economic ways to fabricate wells and microenvironments for electrochemical sensors on flexible substrates.

### Summary of the Invention

The present invention is directed to a flexible sensor according to claim 1 and to a method for fabricating a sensor according to claim 10.

In certain embodiments, the present invention is directed to methods for fabricating a plurality of sensors on a flexible substrate, each sensor having at least one associated electrode and at least one well. As used herein, the term "well" means a reservoir or chamber used to receive or hold a quantity of fluid therein (typically sized and configured as a microfluidic environment). As such, the term "well" includes at least one discrete chamber or a plurality of chambers (in fluid communication or in fluid isolation, as the application desires) and can alternatively or additionally include one or more channels (linear or other desired complex or irregular shapes (such as spiral, annular, etc.)), or combinations of a well(s) and channel(s).

In certain embodiments, the method includes: (a) providing a flexible substrate material layer having a surface area defined by a length and width thereof; (b) forming a plurality of sensors onto the flexible substrate material layer, each sensor comprising a predetermined metallic pattern defining at least one electrode; (c) disposing at least one coverlay sheet over the flexible substrate sandwiching the sensors therebetween, the coverlay sheet having an associated thickness; (d) laminating the at least one coverlay sheet to the flexible substrate layer; and (e) removing predetermined regions of the laminated coverlay sheet from the flexible substrate layer to define a well (which may be or include a channel) with a depth corresponding to the thickness of the coverlay sheet.

In certain embodiments, the removing step also exposes a portion of the underlying metallic pattern of each sensor (such as bond pads and an interdigitated array or "IDA"). The array of sensors can be arranged such that the sensors are aligned back to back and side by side to occupy a major portion of the surface area of the flexible substrate. In addition, the patterned coverlay can be configured such that the well is a microfluidic channel or a channel with a well. In certain embodiments, the assembly may be configured such that there are openings in the coverlay for bond pads and the like to make any desired electrical connection(s).

Other embodiments of the invention are directed to arrays of flexible sensors. The arrays of flexible sensors include: (a) a flexible substrate layer having opposing primary surfaces, (b) an electrode layer disposed as a repetition of metallic electrically conductive patterns on one of the primary surfaces of the substrate layer, the metallic pattern corresponding to a desired electrode arrangement for a respective sensor; and (c) a first coverlay sheet layer having a thickness overlying and laminated to the first flexible substrate layer to sandwich the electrode layer therebetween. The third coverlay sheet layer has a plurality of apertures formed therein. The apertures define a well for each of the sensors on the flexible substrate. The wells have a depth corresponding to the thickness of the coverlay sheet layer.

Other embodiments are directed to flexible sensors, which can be single use or disposable bioactive sensors. Similar to the array of sensors, the individual sensors can be multi-layer laminated structures including: (a) a flexible substrate layer; (b) an electrode layer comprising a conductive pattern of material disposed onto one of the primary surfaces of the first flexible substrate layer; and (c) a first flexible coverlay layer overlying the electrode layer and laminated to the electrode layer and the substrate layer, wherein the first flexible coverlay layer has a well formed therein, the well having a depth of at least about 1-10 mils (.001-.01 inches) or, in a metric system, at least about 25-250 µm. Of course greater well depths can also be generated, such as by using thicker coverlay sheets or combinations of sheets, to yield well depths of about 12 mils (about 300 µm) or more, depending on the application.

In certain embodiments, the array of sensors or each sensor can include a second coverlay layer having a thickness of between about 1-10mils overlying and secured to the first coverlay layer. The second coverlay layer also has a plurality of apertures formed therein, the apertures corresponding to the apertures in the first coverlay layer. Thus, the wells have a depth corresponding to the combined thickness of the first and second coverlay layers. In other embodiments, a third coverlay layer can also be employed by laminating it to the second coverlay layer and removing the material overlying the well site to provide a well depth corresponding to the thickness of the first, second, and third coverlay layers.

The method of fabricating the sensor arrays can be carried out in an automated continuous production run that increases the production capacity over batch type processes. In addition, the wells can be formed with increased volume, capacity, or depth over conventional microfabrication techniques. The method can be performed such that the sensors are arranged on the flexible substrate in a high-density pattern of at least about 4 sensors per square inch when measured over about 122 square inches. In other high-density embodiments, for a sheet which is 12 inches by 12 inches (144 square inches), about 750 sensors can be arranged thereon, averaging at least about 5 sensors per square inch. In certain embodiments, the sensors and arrays are configured to be heat resistant or to withstand sterilization procedures suitable for biomedical products.

The coverlay material is a photosensitive dry film material. Examples of suitable coverlay materials include photoimageable polymers, acrylics, and derivatives thereof including, but not limited to, commercially available PYRALUX® PC and VACREL® from DuPont, and CONFORMASK® from Morton. In addition, the coverlay sheet may be a pre-laminated sheet of a plurality of plies of one or more types and/or varying thickness of dry film coverlay materials and may also include desired coatings.

The foregoing and other objects and aspects of the present invention are explained in detail in the specification set forth below.

### Brief Description of the Drawings

**Figure 1** is a flow chart of method steps for fabricating sensors with wells on a flexible substrate according to embodiments of the present invention.
**Figures 2a-2g** are side views of a fabrication sequence of flexible substrate sensors using coverlay sheet material according to embodiments of the present invention.
**Figures 3a-3g** are top views of the sequence shown in **Figures 2a-2g****,** (with Figures 2a and 3a correspond to one another, Figures 2b and 3b corresponding to one another and so on.
**Figure 4** is a flow chart of the sequence of fabrication steps illustrated in **Figures 2** and 3.
**Figure 5** is a photocopy of the upper surface of a partial sheet of an array of sensors with wells on a flexible substrate according to embodiments of the present invention.
**Figure 6a** is a greatly enlarged side perspective view of a sensor with a well according to embodiments of the present invention.
**Figure 6b** is a greatly enlarged side perspective view of a sensor with a well having a depth corresponding to the combined thickness of multiple coverlayer sheets.
**Figure 7** is a top view of a partial sheet of an array of sensors drawn to scale according to embodiments of the present invention.
**Figures 8a-8i** are schematic illustrations of stations in a production line for fabricating arrays of flexible sensors according to embodiments of the present invention.

### Description of Embodiments of the Invention

The present invention will now be described more fully hereinafter with reference to the accompanying figures, in which preferred embodiments of the invention are shown. This invention may, however, be embodied in many different forms and should not be construed as limited to the embodiments set forth herein. Like numbers refer to like elements throughout. In the figures, layers, components, or features may be exaggerated for clarity.

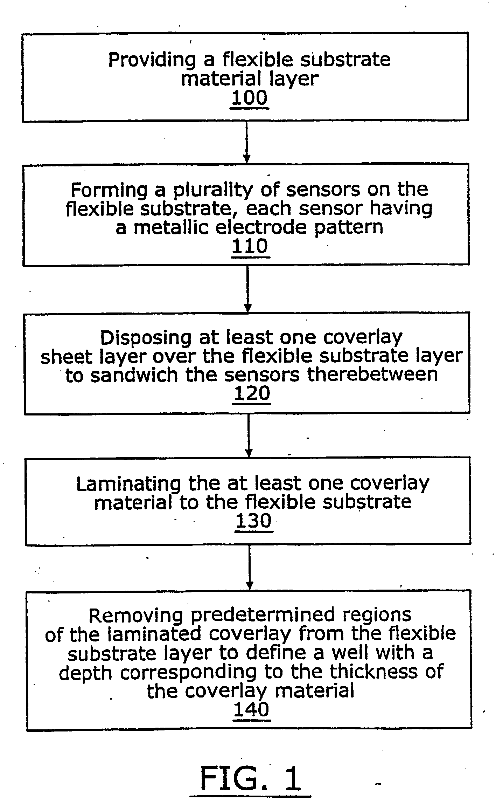

In certain embodiments, as shown in **Figure 1****,** steps for fabricating a flexible sensor can include first providing a flexible substrate material layer **(Block 100).** The flexible substrate material layer can be an elastomeric film such as polyimide films. Examples of commercially available films include, but are not limited to, Kapton®, Upilex®, Kaladex® and the like. Next, a plurality of sensors can be formed on the flexible substrate layer via depositing or forming a desired conductive and/or metallic electrode pattern thereon **(Block 110).** Any suitable metal trace fabrication technique may be employed, such as sputtering or deposition of the metal followed by photolithography or laser ablation, stenciling, screen-printing, shadow masking, and the like.

In any event, after the metallic pattern is formed on the substrate, at least one coverlay sheet layer having an associated thickness can then be disposed to overlie the flexible substrate layer so as to sandwich the sensors or metallic pattern therebetween **(Block 120).** The coverlay sheet can be a photosensitive and/or photoimageable coverlay dry film material. Examples of suitable coverlay materials include photoimageable polymers, acrylics, flexible composites, and derivatives thereof including, but not limited to, commercially available PYRALUX® PC and VAGREL® from DuPont, and CONFORMASK® from Morton. In addition, the coverlay sheet may be a pre-laminated sheet of a plurality of plies of one or more types and/or varying thickness of dry film coverlay materials and may also include desired coatings. The coverlay material maybe selected so as to be heat resistant or compatible with irradiation sterilization procedures as, in use, the sensor may be exposed to sterilization procedures, particularly for biomedical applications.

The coverlay sheet is laminated to the underlying flexible substrate layer (*i.e*., the layers are united) **(Block 130).** The layers can be united by hot roll lamination techniques, or other suitable lamination means suitable to unite the layers together. Predetermined regions of the laminated coverlay sheet can be removed from the flexible substrate layer to define a well with a depth corresponding to the thickness of the coverlay sheet layer **(Block 140).** In certain embodiments, two or more coverlay sheets can be laminated, serially, onto the flexible substrate to define a well with a depth corresponding to the combined thickness of the coverlay sheets used.

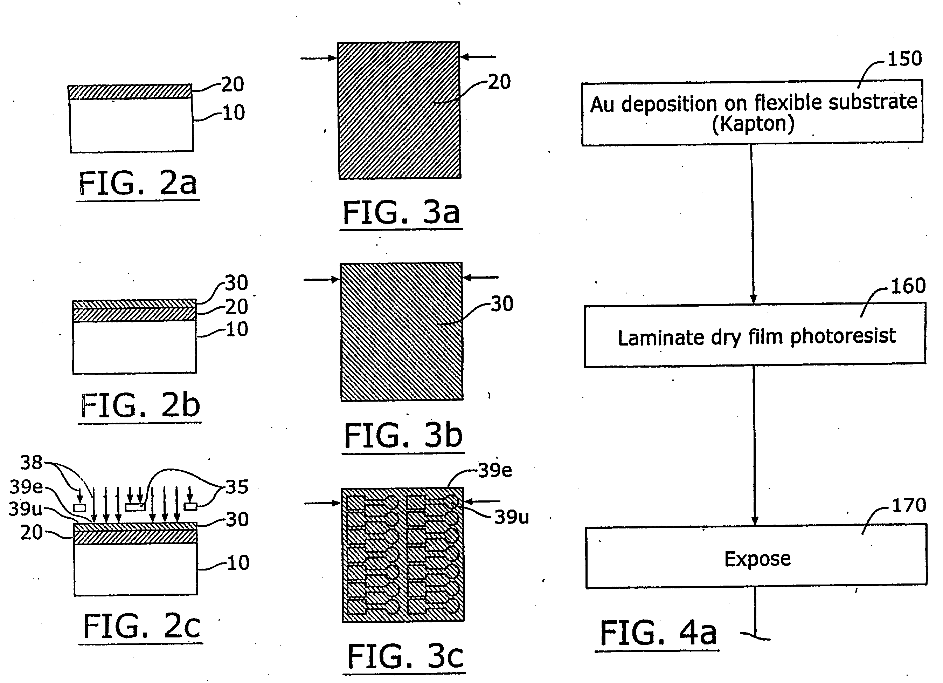

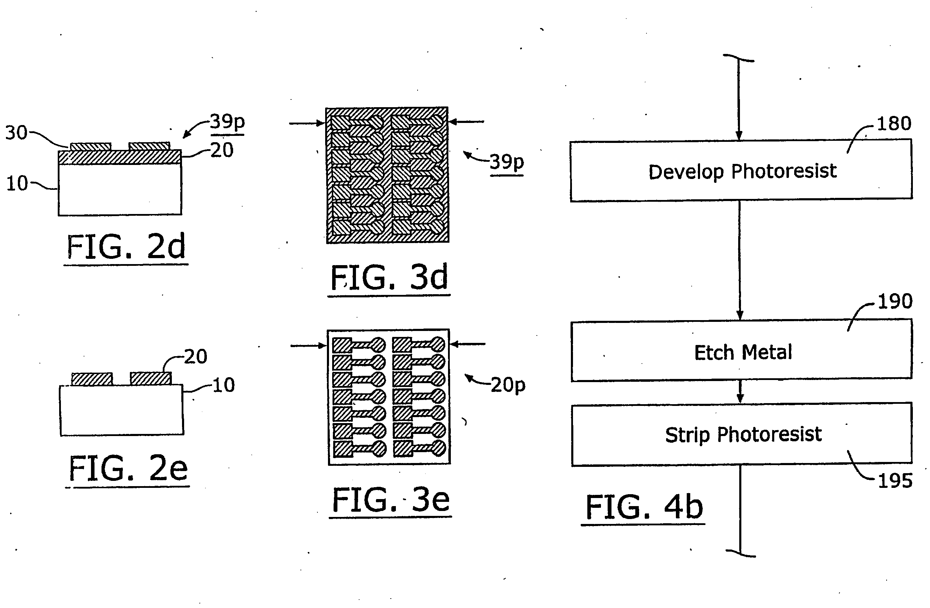

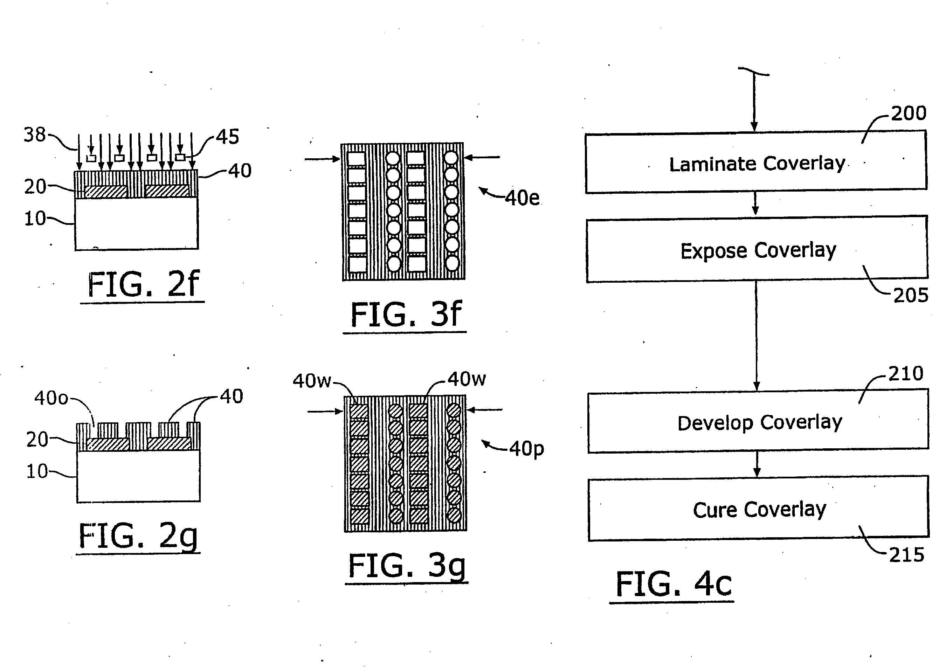

**Figures 2** and **3** illustrate a sequence of operations, suitable for certain embodiments, which can be used to form a flexible sensor array (which can be separated to form individual disposable sensors as will be discussed further below). As shown in **Figure 2a** and **3a****,** first a conductive metal **20** can be deposited onto the flexible substrate layer **10 (Block 150,** **Figure 4****).** The conductive metal **20** can be any suitable conductor as is well known to those of skill in the art, including, but not limited to, gold, silver, platinum, palladium, titanium, chromium and mixtures thereof. In certain embodiments, the metal **20** can be formed as a relatively thin layer of about 30-200nm, and is typically about 100nm. The metal **20** can be applied via a sputtering process. A suitable metal coated flexible substrate material is available from Techni-Met, Inc., located in Windsor, CT. Additional additives such as adhesive enhancing materials (such as seed layers of chromium or titanium) can be sputtered or sprayed or otherwise deposited onto the substrate **10** to promote the adhesion of the metal **20** to the substrate layer **10.**

As shown in **Figures 2b** and **3b****,** a dry film photoresist material layer **30** can be laminated onto the metal layer **20 (****Figure 4****, Block 160).** The photoresist material **30** can be a dry film resist such as Riston® CM206 from DuPont Industries. The photoresist material **30** may be wet laminated by hot rolling the photoresist onto the metal coated surface **20** of the substrate using a HRL-24 hot roll laminator (also available from DuPont). Subsequently, as shown in **Figure 2c****,** a photomask **35** with a predetermined mask pattern is positioned between the photoresist material **30** and an ultraviolet light source and the ultraviolet light **38 travels** through desired apertures in the mask **35** to expose photoresist material about the unmasked regions **39e** but not the masked regions **39u,** thereby forming a desired exposure pattern in the laminated dry film photoresist material **30.** Thus, predetermined regions of the photoresist material are exposed **(****Figure 4****, Block 170).** In the embodiment shown, a negative photoprocessing system is employed, the mask being configured to cover the regions (and prevent exposure) which will define the desired trace or electrode pattern. However, a positive imaging or photoprocessing technique can also be used as is well known to those of skill in the art.

As shown in **Figures 2d** and **3d****,** the photoresist material **30** is then developed **(****Figure** 4, **Block 180),** leaving the patterned photoresist **39p** on the surface (the exposed regions being removed). **Figures 2e** and **3e** illustrate that next the metal pattern is etched into the metal layer **20** corresponding to the laminated photoresist material remaining thereon **(****Figure 4****, Block 190).** As shown in **Figures 2e** and **3e****,** after the metal pattern **20p** is formed, the remainder of the photoresist material **30** is removed or stripped **(****Figure 4****, Block 195),** leaving the substrate layer **20** with the desired metallic pattern **20p** thereon.

Next, as shown in **Figures 2f** and **3f** (and **Figure 4****, Blocks 200, 205),** a coverlay material **40** is laminated onto the flexible substrate **10** sandwiching the metallic pattern **20p** therebetween. The lamination can be performed as a hot roll process, which presses the two layers together. The lamination can be carried out under vacuum to help remove air which may be trapped or residing between the two joining surfaces.

As before, **Figures 2f** and **3f** illustrate that photolithography can be used to expose desired regions **40e** of the coverlay material **40,** which is then selectively removed (or if desired, the reverse processing can be used, *i*.*e*., the unexposed material can be removed) thereby forming the desired pattern in the coverlay material **40p,** which then forms the well and/or exposes the underlying **metal 20** or substrate material **10.** The exposed material is removed about a well region formed by the selective removal of the coverlay material **40,** the **well 40w** having a depth corresponding to the thickness of the coverlay. As shown in **Figure 2f****,** a mask **45** is positioned between an ultraviolet light source and the light rays travel through openings in the mask **45** to expose the predetermined regions in the coverlay material **40.** The coverlay material is then developed **(****Figure 4****, Block 210)** and the unwanted coverlay material **40** is removed or stripped, leaving a flexible array of sensors with surface regions exposed to the underlying material (either the flexible substrate **10,** or the metal layer **20).** The coverlay material can then be cured **(****Figure 4****, Block 215).** Any suitable curing technique can be employed, but typically a thermal curing process is employed to heat the coverlay material to desired temperatures and for desired cure times to thermally cross-link the coverlay material. Doing so "permanently secures" the coverlay material(s) to the underlying substrate and/or to inhibit the degradation or separation of the structure in use (maintaining the integrity of the attachment between the coverlay material and the underlying materials). Other curing means may be used, as suitable, depending on the materials employed, including, but not limited to, oven or other heat source, microwave, RF, or ultrasound energy, and/or laser, ultraviolet light or other light source.

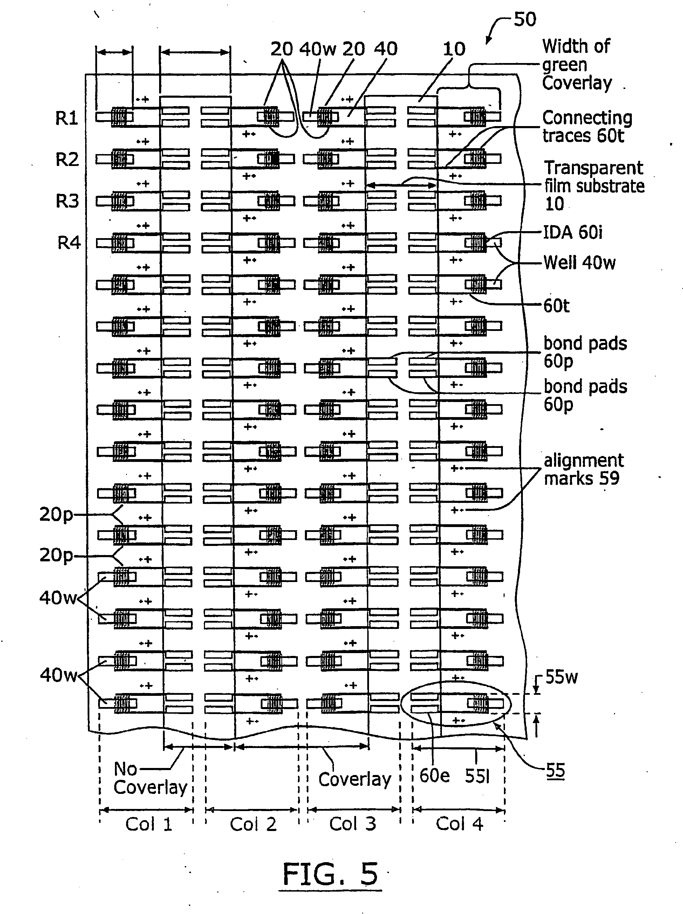

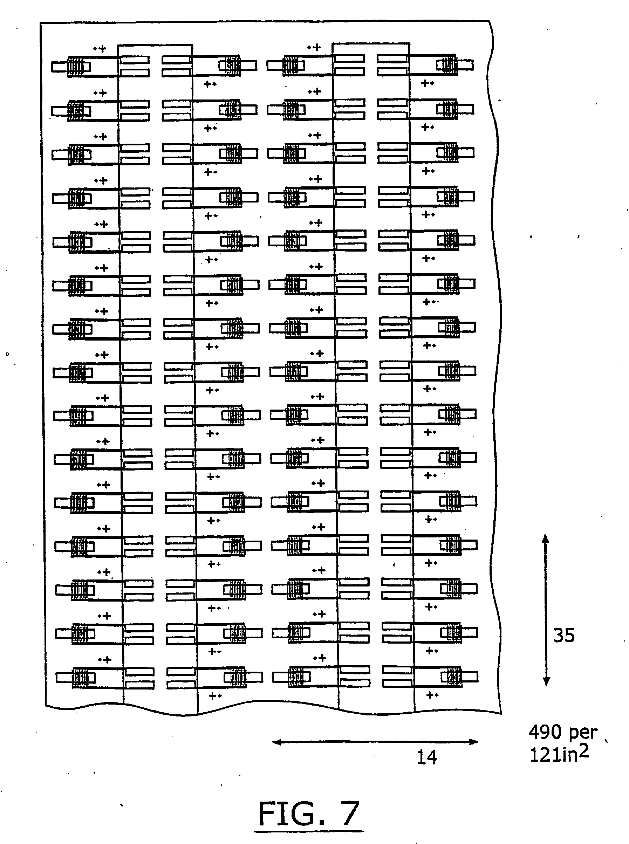

**Figure 5** illustrates an example of an array of flexible sensors **50** according to certain embodiments of the invention. As shown, the array **50** can be fabricated so as to provide a plurality of sensors **55.** In certain embodiments, adjacent sensors **55** are arranged side-by-side and back-to-back or otherwise oriented to provide a high density arrangement of sensors and/or to occupy a major portion, and typically substantially all, of the surface area of the flexible array **50**. The term "high density" means that, when measured over at least about 0.0778 m² (121in²) (typically in a square sheet of about 0.279x0.279 m (11x11 inches)), on average, the array **50** holds about 490 sensors **55** or at least about 4 complete sensors 55 per 0.0778 m² (square inch). In certain embodiments, when measured over a 0.305x0.305 m (12x12 inch) area, the array can hold about 750 sensors, or at least about b sensors on average. **Figure 7** illustrates an exemplary layout of a partial sheet of an array **50'** of sensors drawn to scale; the array **50'** can be produced with at least 35 sensors in the vertical direction and 14 sensors in the horizontal direction (the 35x14 array shown corresponds to an 11x11 sheet). Of course, other array sizes can be used and the sensors themselves further miniaturized or enlarged, depending on the desired application.

As shown in **Figure 5****,** the sensors **55** can be symmetrically arranged in columns (the column width corresponding to the length of the sensor **551**) and rows (with the row height corresponding to the width of the sensor **55w**), with gap spaces positioned adjacent each sensor **55** to facilitate separation from the array **50** for individual use so as to inhibit damage to the adjacent sensor upon removal. The array **50** can include alignment marks **59** that can facilitate the alignment of masks and system components with the metal pattern of individual sensors or groups of sensors on the array **50** during fabrication.

It is noted that the sensors **55** on the array **50** (including the depth of the well **40w** and metal pattern **20p** which defines the desired electrical or electrode arrangement) can be alternately configured, shaped, and arranged. For example, the sensor length **551** can be disposed vertically on the flexible substrate **10** such that the row height corresponds to the length of the sensor or the electrode can include curvilinear traces or circular, triangulated, or other electrode shapes. In **Figure 5** and **7**, the darkest regions correspond to locations where the laminated overlay was removed from the underlying flexible substrate, exposing either the underlying substrate or a portion of the metallic pattern **20p.** The lighter regions correspond to locations where the laminated coverlay material **40** remains intact (sandwiching a portion of the underlying metal pattern **20p** to the flexible substrate **10**).

As shown in **Figure 5****,** the array **50** is planar and includes a metallic pattern formed on one primary surface of the underlying flexible substrate **10,** each sensor **55** including a metallic pattern which defines the arrangement of at least one electrode **60e.** In the embodiment shown in **Figures 5-7****,** the electrode **60e** includes two spaced apart bond pads **60p,** each having a respective connecting trace **60t,** and an interdigitated array (IDA) **60i.** In certain embodiments, the IDA can have a structure width which may be in the sub-µm range. In the embodiment shown, the IDA 60i is positioned in the **well 40w.** For additional information on IDA's, see, *e.g.,* U.S. Patent No. 5,670,031 and WO 97/34140. *See also,* Niwa et al; Fabrication and characteristics of vertically separated interdigitated array electrodes, J. Electroanal. Chem., 267, pp. 291-297 (1989); Koichi Aoki, Theory of the steady-state current of a redox couple at interdigitated array electrodes of which pairs are insulated electrically by steps, J. Electroanal. Chem. 270, pp. 35-41 (1989); Koichi Akoi, Quantitative analysis of reversible diffusion-controlled currents of redox soluble species at interdigitated array electrodes under steady state conditions, J. Elctroanal. Chem. 256, pp. 269-282 (1988); and Horiuchi et al., Limiting Current Enhancement by Self-Induced Redox Cycling on a Micro-Macro Twin Electrode, J. Electrochem. Soc., Vol. 138, No. 12 (Dec. 1991).

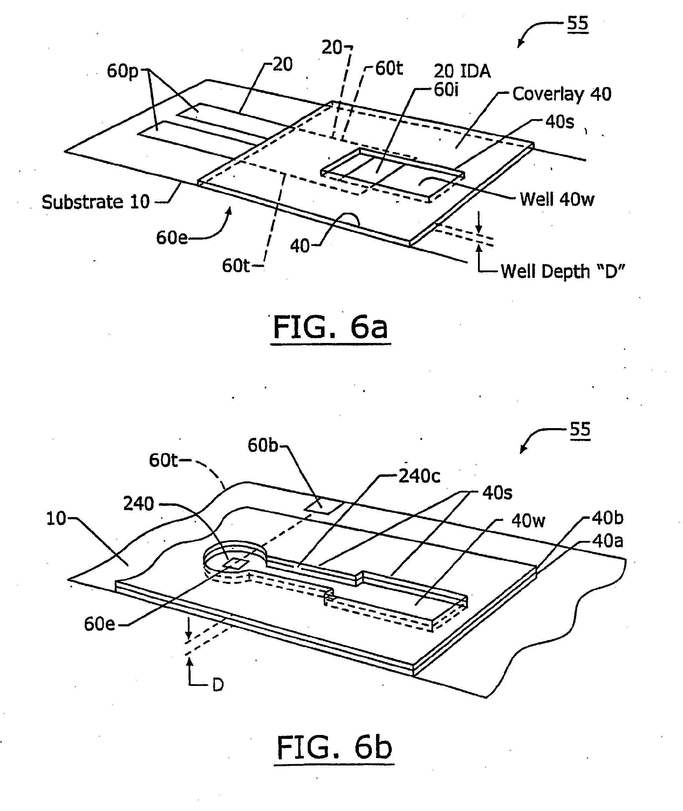

**Figure 6a** illustrates a greatly enlarged sensor **55.** As shown, the sensor **55** includes a well **40w** having a depth "D" which corresponds to the thickness of the coverlay sheet(s) **40** laminated to the flexible substrate **40.** **Figure 6b** illustrates that the well **40w** can have a depth "D" corresponding to the combined thickness of two laminated coverlay sheets, **40a, 40b.** As noted above, one, two, or three or more sheets **40** can be used to generate the desired well depth. The sheets (shown in **Figure 6b** as **40a, 40b**) can have the same or a different thickness and/or can be formed from the same material(s) or different material(s). For example, three sheets, each having a thickness of about 4 mils, can be used to define a well **40w** with a 12 mil depth. Alternatively, a 3 mil and 2 mil sheet can be used to provide a well **40w** with a 5mil depth.

As also noted above, the coverlay sheet **40** can be a pre-laminated sheet of a plurality of plies of materials with or without coatings. In addition, as also noted above, the coverlay sheet(s) **40** can have a thickness of at least 0.5-10 mils (about 12-250 µm) and preferably has a thickness of about 1-20 mils (about 25-500 µm) or more. In certain embodiments, the wells **40** have a depth which is in the range between about 5-15mils.

In certain embodiments, the coverlay sheet(s) **40** are selected to define a well depth "D" and perimeter shape **40s** which is consistent from sensor to sensor **55** to provide a consistent testing space or volume. This can allow for improved meting of the biological fluid undergoing analysis, thus helping to provide a more consistent sample size to combine with the electrochemical formulation or solution or chemical substance(s) which may also be contained in the well **40w** (not shown). In turn, reducing variation in the sensor operation can promote more reliable test results. Additional description of electrodes and analyte formulations are found in co-pending U.S. Patent Application identified by Attorney Docket No. RDC0002/US, entitled "ELECTRODES, METHODS, APPARATUSES COMPRISING MICROELECTRODE ARRAYS".

As shown in **Figure 6a****,** the well **40w** can be in fluid communication with an IDA **60i** or electrode **60e** of a desired configuration which is in electrical communication with opposing electrical connecting traces **60t.** Typically, the well **40w** has a configuration which opens the laminated coverlay **40** to expose the underlying IDA or electrochemical active components while defining the perimeter shape **40s** in a precise repeatable manner to generate a consistent reliable testing environment part to part.

As shown in **Figure 6b****,** the well can be in fluid communication with a capillary segment **240c** having a depth "D" (which is typically the same depth as the well) which directs fluid from the well **40w** through the capillary segment **240c** to the active test well **240w.** The test well **240w** may be configured to house an IDA as noted above, or other desired electrical component or electrode **60e,** and/or a chemistry formulation corresponding to the test protocol for the particular sensor application. The sensor **55** can also include one or more electrical traces **60t** and one or more bond pads **60b** configured, in operation, to be electrically engageable with a testing device capable of receiving and analyzing the signal of the sensor **55** (not shown).

In certain embodiments, the testing device can be a home unit and the sensor can be a disposable (typically, a single use disposable) sensor suitable for use by a patient, for example, to monitor glucose or other analyte levels (or the presence or absence of substances) in the blood or other body fluid or sample. It will be appreciated that the shape, length and configuration of the electrode or metallic pattern as the well shape, configuration or depth can vary depending on the desired end application.

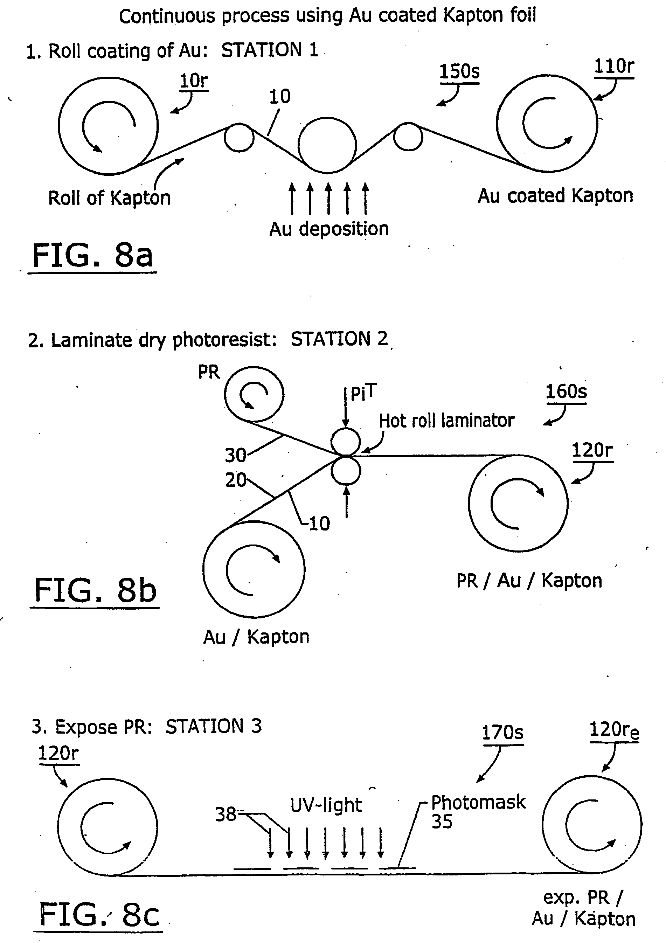

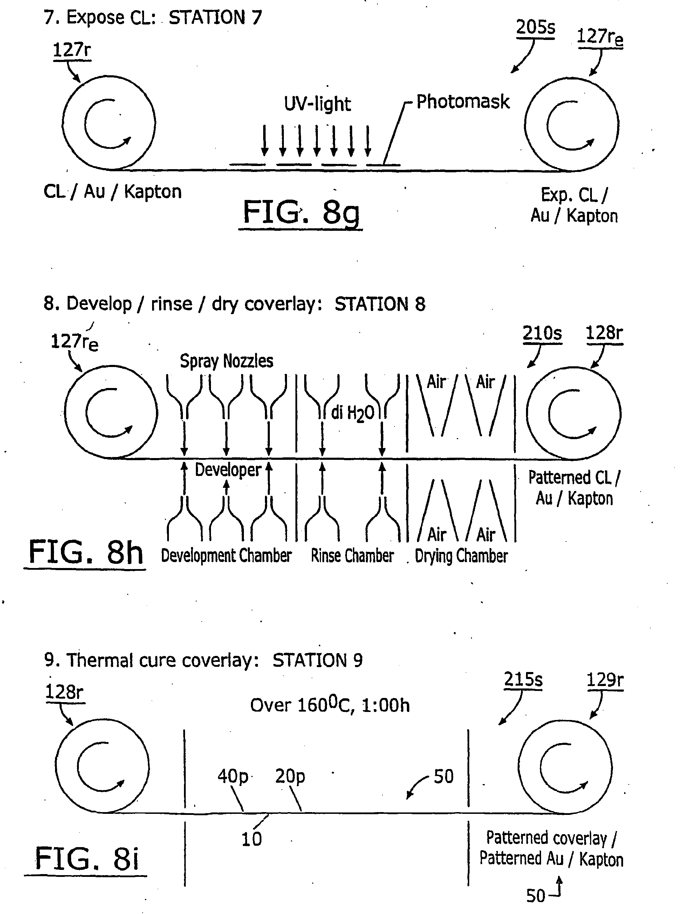

Turning now to **Figures 8a-8i****,** an exemplary embodiment of a production line with nine production workstations is shown. In certain embodiments, the production line can be configured to be automated and semi-continuous or continuous. The word "continuous" means that a production run of a desired quantity or length of material can be processed serially through each of the stations and is operated generally without substantial time delay or disruption between stations (*i.e*., certain delays are expected such as for set-up, tool change, material introduction, maintenance, queues at equipment, shift changes, planned and unplanned downtime, etc). The term "semi-continuous" as used herein, means that fabrication of the array of sensors is carried out by maintaining the product on reels of desired "continuous" lengths through selected stations. Typically, the reels of material are sufficient in length to have continuous production runs through at least the lamination and patterned coverlay stations (shown as stations 6-8). Of course, the in process or processed reels at any particular station may be queued or stored for the next workstation depending on capacity, orders, and the like. That is, for the embodiment shown, reels of flexible substrates and photoresist material as well as coverlays can be used to automatically run the processing steps in each station to form the patterned coverlay laminated to the flexible substrate and electrode surface, preferably even through any desired final curing station (shown as station 9, **Figure 8i****).** In addition, the flexible substrate **10** may be cut to form individual sheets at selected points during the process. However, by using reels of arrays or materials, the fabrication process can be automated and run in continuous lengths of material in relatively long production runs (in contrast to batch mode production operations).

Although shown as nine separate workstations in **Figures 8a-8i****,** for ease of discussion, it is noted that some of the stations can be multipurpose or combined with other workstations. For example, one or more of stations 2 and 6, stations 3 and 7, and/or stations 4 and 8 may be configured to be the same physical station or equipment, but configured to laminate, expose, or remove the appropriate material, depending on the desired processing step for that particular product run. In addition, the material is illustrated as being rerolled onto reels at the end of each workstation; however, alternatively, certain or all of the stations can be arranged to directly feed the material to the next workstation (which can be located downstream of the previous workstation) to provide direct material throughput without rolling onto reels station to station. Also, the gold or metal deposited flexible substrate may be pre-fabricated or obtained from a supplier and patterned locally by the process described at workstations 2-9.

For clarity, the workstations have been identified with feature numbers which correspond to the method steps shown in **Figure 4** (*i.e*., workstation **150s** corresponds to the workstation where the method step **150** of depositing gold onto the flexible substrate can be carried out).

Turning now to **Figure 8a****,** as shown, a roll coating station **150s** conveys or pulls (or otherwise processes) the flexible substrate material **10** so as to coat a selected primary surface with the desired metal (such as gold). As shown, a reel of flexible substrate **10r** (shown as Kapton®) is processed to include the metal (labeled as Au) on one of the primary surfaces. The metal coated substrate material is then rolled into a reel **110r.** As shown in **Figure 8b****,** a laminating station **160s,** takes the material reel **110r** and combines it with a photoresist film ("PR") **30** to laminate to the underlying metallized surface of the flexible substrate **10** by pressing the materials together via rollers in a hot roll-laminating machine at selected pressures and temperatures; P; T. The laminated photoresist **30,** metal **20,** and flexible substrate **10** are then rolled onto **reel 120r.**

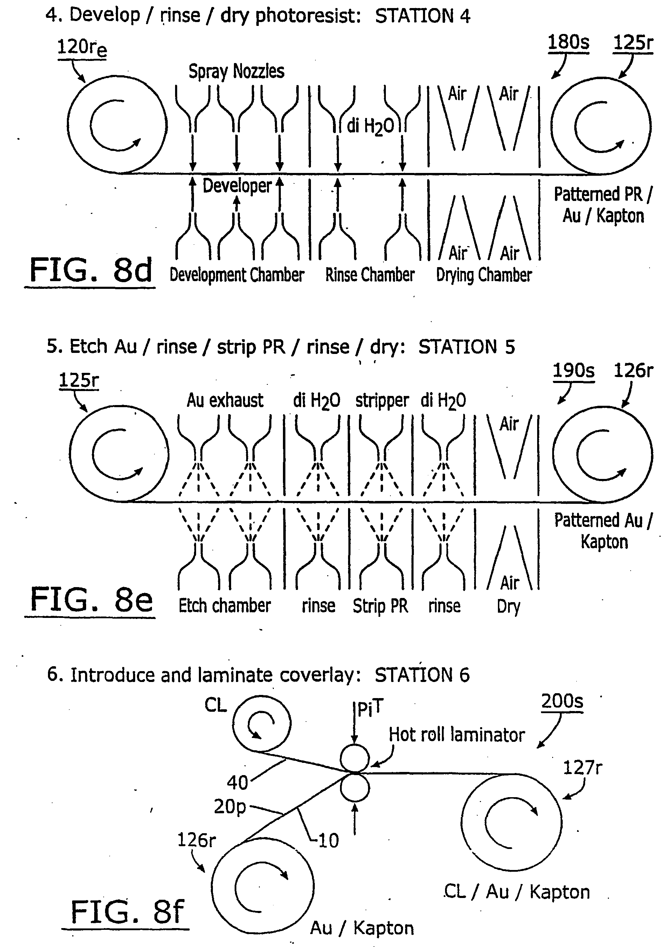

**Figure 8c** illustrates an exposing station **170s,** where material reel **120r** is unrolled and the PR **30** exposed to the ultraviolet light **38** through a mask **35** with a predetermined exposure pattern and the material is re-rolled onto a reel **120rₑ** which now holds the exposed PR, metal, and flexible substrate. The material on reel 120rₑ is then introduced to a developing station **180s,** as shown in **Figure 8d** where the PR is developed, rinsed and dried, resulting in a composition of patterned PR on metal and flexible substrate which can be rolled onto a reel **125r.** As shown in **Figure 8e****,** the material on reel **125r** can then be introduced to an etching station **190s** where the metal can be etched, the PR stripped, and the patterned metal **20p** on flexible substrate 10 dried and rolled onto reel **126r.**

**Figure 8f** illustrates a coverlay application station **200s,** where the coverlay sheet **40** can be introduced as a substantially continuous reel of material **40r** and the flexible substrate with the metallic pattern can also be introduced as a continuous reel of material. The continuous lengths of materials can be forced together so that the coverlay sheet **40** is secured to the underlying materials. As shown, the coverlay sheet is laminated or united to the patterned metal surface **20p** and the underlying flexible substrate in a hot roll lamination machine which presses the two materials together (which may be evacuated during the procedure to reduce the likelihood that air is trapped between the layers). The laminated coverlay **40,** metal pattern **20p,** and flexible substrate **10** can then be rolled onto a reel **127r.** Although not shown, step 6 can be repeated as desired to laminate additional coverlay material sheets onto the first laminated coverlay surface.

**Figure 8g** illustrates a coverlay exposure station **205s,** where the laminated coverlay material **127r** is exposed to a light source (similar to the photoresist material processed at station 3) and collected and rolled to form a reel **127rₑ** of exposed coverlay material on patterned metal **20p** and flexible substrate **10.** The reel exposed coverlay material **127rₑ** is then taken to developing station **210s (****Figure 8h****),** where the coverlay material 40 is developed to yield a laminated patterned coverlay layer **40p** overlying a patterned metal surface **20p** on the flexible substrate **10** which can be collected on a reel **128r.** The reel of material **128r** can then be directed to travel through a thermal curing station **205s** to cure the coverlay material **40** (for example, an oven at about 160°C with a conveying tension and speed set so that the coverlay sheet is cured for about 1 hour). Of course, other temperatures and times (and related conveyor speeds can also be used). In addition, a more complex array continuous travel pattern (not shown) can be used to occupy more of the space in the oven (*i.e*., spiral or zig-zag to use more vertical space). Alternatively, the array **50** can be cut into desired lengths and conveyed through the oven. As shown, the continuous length of array **50** is rolled onto a finished array material spool or reel **129r** which can be transported to a pharmaceutical location where a desired chemical formulation can be added to the wells and the sensors split into individual units.

It is also noted that, in certain embodiments, an additional coverlay layer or layers can be positioned to define a ceiling or lid over the underlying laminated coverlay defining the well(s) (not shown). The ceiling coverlay layer can be configured to enclose the underlying surface or portions of the surface such as to enclose the well. The enclosed well configuration may be particularly suitable for enclosed microfluidic testing environments. The ceiling coverlay layer may be patterned to define a port or openings in the ceiling layer to allow electrical or fluid access to desired regions thereunder. In certain embodiments, a port can be patterned into the ceiling coverlay to allow fluid passage to a portion of the well. In other embodiments using enclosed well (chamber and/or channel) configurations, the fluid travel passage can be provided through vias or passages formed up through the substrate layer or formed laterally through an intermediate layer (such as, when viewed from the top, a lateral passage extending from an open end region to the testing well). In these embodiments, an additional ceiling forming set of stations (similar to those used to form the coverlay(s) defining the wells onto the substrate can be used to laminate the ceiling coverlay to the underlying structure and/or pattern the ceiling coverlay as desired.

The invention is explained in greater detail in the following non-limiting examples.

### Examples

The following process was used to prepare an article according to embodiments of the invention. According to the method, a gold film or layer is deposited onto a flexible substrate formed of 7 mil thick Kaladex® film using a planar DC magnetron sputtering process and equipment operated Techni-Met Inc. (a roll coating company), located in Windsor, CT. The thickness of the gold film can range from 30 to 200 nm, with a preferred thickness being about 100nm. Seed layers of chromium or titanium can be sputtered between the substrate film and the gold layers to promote better adhesion of the gold to the substrate film; however, gold layers sputtered directly onto the substrate film without such seeding can exhibit sufficient adhesion. Plasma treatment of substrate surface can improve the adhesion of gold.

After the gold was applied to the flexible substrate, a dry film photopolymer resist was laminated to the gold/substrate film. A dry film resist such as that sold under the trademark Riston® CM206 (duPont) was used. The Riston® CM206 photoresist was first wet laminated onto the gold surface of 12" x 12" gold/substrate panels using a HRL-24 hot roll laminator (from duPont). The sealing temperature and lamination speed were about 105°C and 1 meter per minute, respectively. The laminated panel was placed in a Tamarack model 152R exposure system, from Tamarack Scientific Co., Inc., Anaheim, CA. The release liner was removed from the top surface of the photoresist. A glass/Cr photomask was produced by Advance Reproductions Corporation, North Andover, MA. The Cr side of the mask was treated with an antistick coating (Premitech Inc., Raleigh, NC), and was placed directly onto the photoresist surface of the panel. The laminated panel was exposed to ultraviolet light of 365 nm through the photomask using an exposure energy of 60 mJ/cm². Unexposed photoresist was stripped from the panel in a rotary vertical lab processor (VLP-20), Circuit Chemistry Equipment, Golden Valley, MN, using 1% potassium carbonate, at room temperature, for 30 seconds using a nozzle pressure of 34 psi. Exposed gold on the sheet was then stripped using an etch bath containing a solution of 4 parts I₂:1 par KI:40 parts water vol./vol.; and 0.04 gram Fluorad™ fluorochemical surfactant FC99, (3M, St. Paul, MN) per 100 gram solution, added to the bath to ensure wetting of the gold. Air was bubbled through the bath during the etch process to obtain a sufficiently uniform agitation of the bath mixture. The panel was rinsed with deionized water and residual Riston® CM206 was removed in a 3% KOH bath.

Articles were fabricated using dry film photoimageable coverlay materials such as that sold under the trademark Vacrel® 8140 (and related series) from duPont or Pyralux® PC series (duPont). The chamber dimensions can be accurately defined by flex circuit photolithography. Depth of the chamber was controlled by the thickness of the coverlay materials used and/or whether single or multiple layers of the coverlay dry film were used. Chamber depth was achieved by sequential lamination of different coverlay materials as follows: four mil thick Vacrel® 8130 was first laminated to the electrode side of the substrate using a HRL024 (duPont) heated roll laminator at room temperature, using a roller speed of 1 meter per minute. The electrode panel was then vacuum laminated in a DVL-24 vacuum laminator (duPont) using settings of 120°F, 30 second vacuum dwell, and a 4 second pressure dwell to remove entrapped air between the coverlay film and the electrode substrate. Two mil thick Vacrel® 8120 was laminated next to the Vacrel® 8130 surface using the HRL-24 at room temperature, with a roller speed of 1 meter/min. The panel was then vacuum laminated again in the DVL-24 vacuum laminator using a 30 second vacuum dwell, 4 second pressure, to remove entrapped air between the two coverlay films.

The laminated electrode sheet was placed in the Tamarack 152R system and was exposed to ultraviolet light at 365 nm through the photomask for 22 seconds using an exposure intensity of 17 mW/cm². The unexposed coverlay was stripped from the panel using the VLP-20 Circuit Chemistry Equipment) in 1% K₂CO₃, at 140°F, for 75 seconds using a nozzle pressure of 34 psi. The developed laminate structure was rinsed in deionized water, and then cured at 160°C for 1 hour to thermally crosslink the coverlay material.

The foregoing is illustrative of the present invention and is not to be construed as limiting thereof. Although a few exemplary embodiments of this invention have been described, those skilled in the art will readily appreciate that many modifications are possible in the exemplary embodiments without materially departing from the novel teachings and advantages of this invention. Accordingly, all such modifications are intended to be included within the scope of this invention as defined in the claims. In the claims, means-plus-function clauses, where used, are intended to cover the structures described herein as performing the recited function and not only structural equivalents but also equivalent structures. Therefore, it is to be understood that the foregoing is illustrative of the present invention and is not to be construed as limited to the specific embodiments disclosed, and that modifications to the disclosed embodiments, as well as other embodiments, are intended to be included within the scope of the appended claims. The invention is defined by the following claims, with equivalents of the claims to be included therein.

## Claims

1. A flexible sensor comprising:
a flexible substrate layer (10) including a first surface;
an electrode layer comprising a conductive pattern of metall (20p) disposed onto the first surface of said substrate layer; and
a flexible photodefined dry film coverlay sheet (40) laminated to the first surface of said substrate layer, said coverlay sheet defining a testing chamber (40w) positioned to expose at least a portion of said electrode layer.

2. The sensor of claim 1 in which said coverlay sheet is laminated directly to said substrate layer without an intermediately positioned adhesive.

3. The sensor of claim 1 in which said coverlay sheet has a thickness of 25-250 µm.

4. The sensor of claim 1 and which includes a second coverlay overlying and secured to said coverlay sheet.

5. The sensor of claim 4 in which said second coverlay comprises a first photosensitive material and the coverlay sheet comprises a second, different photosensitive material.

6. The sensor of claim 4 in which said second coverlay forms a ceiling over at least a portion of the testing chamber defined by said coverlay sheet.

7. The sensor of claim 1 in which said coverlay sheet further defines a passageway extending from an open end to the testing chamber.

8. The sensor of claim 7 and which includes a second coverlay overlying and secured to said coverlay sheet, said second coverlay forming a ceiling over at least a portion of the testing chamber defined by said coverlay sheet.

9. The sensor of claim 1 in which said coverlay sheet is selected from the group consisting of photoimageable polymers, acrylics, flexible composites, and derivatives thereof.

10. A method for fabricating a sensor with electrodes on a flexible substrate comprising:
providing a flexible substrate layer including a first surface (100);
forming on the first surface of said substrate layer an electrode layer comprising a conductive pattern of metal (110);
laminating a flexible photoimageable dry film coverlay sheet to the first surface of the substrate layer and covering at least a portion of the electrode layer (120, 130); and removing by photoimaging techniques a predetermined region of the coverlay sheet to define a testing chamber positioned to expose at least a portion of the electrode layer (140).

11. The method of claim 10 in which said attaching comprises laminating the coverlay sheet directly to the substrate layer without an intermediately positioned adhesive.

12. The method of claim 10 in which the coverlay sheet has a thickness of 25-250 µm.

13. The method of claim 10 and which further includes attaching a second coverlay overlying and secured to the coverlay sheet.

14. The method of claim 13 in which the second coverlay comprises a first photoimageable material and the coverlay sheet comprises a second, different photoimageable material.

15. The method of claim 14 in which the second coverlay forms a ceiling over at least a portion of the testing chamber defined by the coverlay sheet.

16. The method of claim 10 in which said removing further comprises removing a portion of the coverlay sheet to define a passageway extending from an open end to the testing chamber.

17. The method of claim 16 and which includes attaching a second coverlay overlying and secured to the coverlay sheet, the second coverlay forming a ceiling over at least a portion of the testing chamber defined by the coverlay sheet.

18. The method of claim 10 in which the coverlay sheet is selected from the group consisting of photoimageable polymers, acrylics, flexible composites, and derivatives thereof.

19. The method of claim 10 in which said removing comprises:
selectively exposing at least one predetermined region of the coverlay sheet to ultraviolet light, and
introducing a liquid solution thereon to remove the portion of the coverlay sheet in the predetermined region.

## Patentansprüche

1. Flexibler Sensor, umfassend:
ein flexibles Substrat (10) mit einer ersten Oberfläche;
eine Elektrodenschicht, die ein leitendes Muster aus Metall (20p) umfaßt, auf der ersten Oberfläche der Substratschicht angeordnet; und
eine flexible, fotolithographisch definierte Trockenfilm-Decklagenfolie (40), auf die erste Oberfläche der Substratschicht laminiert, wobei die Decklagenfolie eine Prüfkammer (40W) definiert, die so positioniert ist, daß sie mindestens einen Abschnitt der Elektrodenschicht exponiert.

2. Sensor nach Anspruch 1, wobei die Decklagenfolie direkt auf die Substratschicht ohne irgendwelchen dazwischenpositionierten Kleber laminiert ist.

3. Sensor nach Anspruch 1, wobei die Decklagenfolie eine Dicke von 25-250 µm aufweist.

4. Sensor nach Anspruch 1, der eine zweite Decklage enthält, die über der Decklagenfolie liegt und an dieser gesichert ist.

5. Sensor nach Anspruch 4, bei dem die zweite Decklage ein erstes lichtempfindliches Material umfaßt und die Decklagenfolie ein zweites, anderes lichtempfindliches Material umfaßt.

6. Sensor nach Anspruch 4, bei dem die zweite Decklage eine Decke über mindestens einem Abschnitt der durch die Decklagenfolie definierten Prüfkammer bildet.

7. Sensor nach Anspruch 1, bei dem die Decklagenfolie weiterhin eine Passage definiert, die sich von einem offenen Ende zu der Prüfkammer erstreckt.

8. Sensor nach Anspruch 7, der eine zweite Decklage enthält, die über der Decklagenfolie liegt und an dieser gesichert ist, wobei die zweite Decklage eine Decke über mindestens einem Abschnitt der Prüfkammer bildet, durch die Decklagenschicht definiert.

9. Sensor nach Anspruch 1, bei dem die Decklagenfolie ausgewählt ist aus der Gruppe bestehend aus fotoabbildbaren Polymeren, Acrylen, flexiblen Composites und Derivaten davon.

10. Verfahren zum Herstellen eines Sensors mit Elektroden auf einem flexiblen Substrat, umfassend:
Bereitstellen einer flexiblen Substratschicht mit einer ersten Oberfläche (100);
Ausbilden einer Elektrodenschicht, die ein leitendes Muster aus Metall (110) umfaßt, auf der ersten Oberfläche der Substratschicht;
Laminieren einer flexiblen, fotoabbildbaren Trockenfilm-Decklagenschicht auf die erste Oberfläche der Substratschicht und Bedecken mindestens eines Abschnitts der Elektrodenschicht (120, 130) und
Entfernen eines vorbestimmten Gebiets der Decklagenfolie durch Fotoabbildungstechniken, um eine Prüfkammer zu definieren, die so positioniert ist, daß sie mindestens einen Abschnitt der Elektrodenschicht (140) exponiert.

11. Verfahren nach Anspruch 10, bei dem das Anbringen das direkte Laminieren der Decklagenschicht auf die Substratschicht ohne dazwischenpositionierten Kleber umfaßt.

12. Verfahren nach Anspruch 10, bei dem die Decklagenschicht eine Dicke von 25-250 µm aufweist.

13. Verfahren nach Anspruch 10, das weiterhin das Anbringen einer zweiten Decklage beinhaltet, die über der Decklagenschicht liegt und an dieser gesichert ist.

14. Verfahren nach Anspruch 13, bei der die zweite Decklage ein erstes fotoabbildbares Material umfaßt und die Decklagenfolie ein zweites, anderes fotoabbildbares Material umfaßt.

15. Verfahren nach Anspruch 14, bei dem die zweite Decklage eine Decke über mindestens einem Abschnitt der durch die Decklagenfolie definierten Prüfkammer bildet.

16. Verfahren nach Anspruch 10, bei dem das Entfernen weiterhin das Entfernen eines Abschnitts der Decklagenfolie umfaßt, um einen Durchgang zu definieren, der sich von einem offenen Ende zu der Prüfkammer erstreckt.

17. Verfahren nach Anspruch 16, das das Anbringen einer zweiten Decklage beinhaltet, die über der Decklagenschicht liegt und an dieser gesichert ist, wobei die zweite Decklage eine Decke über mindestens einem Abschnitt der durch die Decklagenfolie definierten Prüfkammer bildet.

18. Verfahren nach Anspruch 10, bei dem die Decklagenfolie ausgewählt ist aus der Gruppe bestehend aus fotoabbildbaren Polymeren, Acrylen, flexiblen Composites und Derivaten davon.

19. Verfahren nach Anspruch 10, bei dem das Verfahren folgendes umfaßt:
selektives Exponieren mindestens eines vorbestimmten Gebiets der Decklagenfolie gegenüber Ultraviolettlicht und
Einleiten einer flüssigen Lösung darauf, um den Abschnitt der Decklagenfolie in dem vorbestimmten Gebiet zu entfernen.

## Revendications

1. Capteur flexible comprenant :
une couche flexible (10) faisant office de substrat englobant une première surface ;
une couche faisant office d'électrode comprenant une impression conductrice de métal (20p) disposée sur la première surface de ladite couche faisant office de substrat ; et
une feuille de fermeture (40) sous la forme d'un film sec flexible photodéfini, stratifiée sur la première surface de ladite couche faisant office de substrat, ladite feuille de fermeture définissant une chambre d'essai (40w) disposée de façon à exposer au moins une portion de ladite couche faisant office d'électrode.

2. Capteur selon la revendication 1, dans lequel ladite feuille de fermeture est stratifiée directement sur ladite couche faisant office de substrat en l'absence d'un adhésif placé en position intermédiaire.

3. Capteur selon la revendication 1, dans lequel ladite feuille de fermeture possède une épaisseur de 25 à 250 µm.

4. Capteur selon la revendication 1 et qui englobe une deuxième couche de fermeture fixée à ladite feuille de fermeture et la recouvrant.

5. Capteur selon la revendication 4, dans lequel ladite deuxième couche de fermeture comprend une première matière photosensible et la feuille de fermeture comprend une deuxième matière photosensible différente.

6. Capteur selon la revendication 4, dans lequel ladite deuxième couche de fermeture forme un plafond par-dessus au moins une portion de la chambre d'essai définie par ladite feuille de fermeture.

7. Capteur selon la revendication 1, dans lequel ladite feuille de fermeture définit en outre un passage s'étendant depuis une extrémité ouverte jusqu'à la chambre d'essai.

8. Capteur selon la revendication 7 et qui englobe une deuxième couche de fermeture fixée à ladite feuille de fermeture et la recouvrant, ladite deuxième couche de fermeture formant un plafond par-dessus au moins une portion de la chambre d'essai définie par ladite feuille de fermeture.

9. Capteur selon la revendication 1, dans lequel ladite feuille de fermeture est choisie parmi le groupe constitué par des polymères photosensibles, des composés acryliques, des composites flexibles, ainsi que leurs dérivés.

10. Procédé pour fabriquer un capteur comprenant des électrodes sur un substrat flexible, comprenant :
la fourniture d'une couche flexible faisant office de substrat, englobant une première surface (100) ;
la formation, sur la première surface de ladite couche faisant office de substrat, d'une couche faisant office d'électrode comprenant une impression conductrice de métal (110) ;
la stratification d'une feuille de fermeture flexible sous la forme d'un film sec photosensible sur la première surface de la couche faisant office de substrat et le recouvrement d'au moins une portion de la couche (120, 130) faisant office d'électrode, et
l'élimination via des techniques de tirage photographique d'une région prédéterminée de la feuille de fermeture pour définir une chambre d'essai disposée de façon à exposer au moins une portion de la couche (140) faisant office d'électrode.

11. Procédé selon la revendication 10, dans lequel ladite fixation comprend la stratification de la feuille de fermeture directement sur la couche faisant office de substrat en l'absence d'un adhésif placé en position intermédiaire.

12. Procédé selon la revendication 10, dans lequel la feuille de fermeture possède une épaisseur de 25 à 250 µm.

13. Procédé selon la revendication 10 et qui englobe en outre la fixation d'une deuxième couche de fermeture fixée à la feuille de fermeture et la recouvrant.

14. Procédé selon la revendication 13, dans lequel la deuxième couche de fermeture comprend une première matière photosensible et la feuille de fermeture comprend une deuxième matière photosensible différente.

15. Procédé selon la revendication 14, dans lequel la deuxième couche de fermeture forme un plafond par-dessus au moins une portion de la chambre d'essai définie par la feuille de fermeture.

16. Procédé selon la revendication 10, dans lequel ladite élimination comprend en outre l'élimination d'une portion de la feuille de fermeture pour définir un passage s'étendant depuis une extrémité ouverte jusqu'à la chambre d'essai.

17. Procédé selon la revendication 16 et qui englobe la fixation d'une deuxième couche de fermeture fixée à ladite feuille de fermeture et la recouvrant, la deuxième couche de fermeture formant un plafond par-dessus au moins une portion de la chambre d'essai définie par la feuille de fermeture.

18. Procédé selon la revendication 10, dans lequel la feuille de fermeture est choisie parmi le groupe constitué par des polymères photosensibles, des composés acryliques, des composites flexibles, ainsi que leurs dérivés.

19. Procédé selon la revendication 10, dans lequel ladite élimination comprend :
l'exposition sélective d'au moins une région prédéterminée de la feuille de fermeture à la lumière ultraviolette ; et
l'introduction d'une solution liquide dans ladite région pour éliminer la portion de la feuille de fermeture dans la région prédéterminée.
